# EUROPEAN PATENT APPLICATION

(11) **EP 2 911 294 A1**
(43) Date of publication of application: **26.08.2015**
(21) Application number: 14305237.1
(22) Date of filing: 20.02.2014
(51) Int. Cl.: H03F 1/32, H03F 1/34, H03F 3/195, H03F 3/24, H03F 3/68, H04B 1/00, H04B 1/04

(54) **Transmitter method for reducing unwanted signal distortions in a multi-band radio frequency signal, transmitter apparatus and network node thereof**

(71) Applicant: ALCATEL LUCENT, 92100 Boulogne-Billancourt (FR)
(72) Inventor: Yu, Xin, 70435 Stuttgart (DE); Wong, James, Richmond, Surrey TW9 3JX (GB); Wiegner, Dirk, 70435 Stuttgart (DE)
(74) Representative: 2SPL Patentanwälte PartG mbB

(57) **Abstract**

The embodiments of the invention relate to a transmitter method for reducing unwanted signal distortions in a multi-band radio frequency signal (MBRFS). The transmitter method contains amplifying an input radio frequency signal (IMBS) comprising at least one first frequency signal (FS1) in a first frequency band (FB1) and at least one second frequency signal (FS2, FS3) in at least one second frequency band (FB2, FB3) by at least one power amplifier (PA) to an amplified multi-band radio frequency signal (AMBS1). The transmitter method further contains manipulating the amplified multi-band radio frequency signal (AMBS2) by at least one electrical component (FM1, FM2, FM3) for decreasing below a predefined power threshold a power of signal distortions (ID1, ID2, ID3, ID4, ID5) of the amplified multi-band radio frequency signal (AMBS2) being localized in at least one frequency range (FR1, FR2, FR3) outside the first frequency band (FB1) and outside the at least one second frequency band (FB2, FB3). The transmitter method even further contains determining a negated error signal (AFBS) based on the signal distortions (ID1, ID2, ID3, ID4, ID5, ID1b, ID2b) being rejected and reflected by the at least one electrical component (FM1, FM2, FM3, T1, T2). The transmitter method further contains coupling the negated error signal (AFBS) to the amplified multi-band radio frequency signal (AMBS1) at an output of the at least one power amplifier (PA) for the amplified multi-band radio frequency signal (AMBS1). The embodiments further relate to a transmitter apparatus (TRA-APP1) adapted to execute the transmitter method and to a network node, which contains the transmitter apparatus (TRA-APP1).

## Description

### FIELD OF THE INVENTION

The present invention relates to radio transmission of multi-band radio frequency signals and, more particularly but not exclusively, to inter-band distortion rejection for fragmented spectrum applications.

### BACKGROUND

This section introduces aspects that may be helpful in facilitating a better understanding of the invention. Accordingly, the statements of this section are to be read in this light and are not to be understood as admission about what is in the prior art.

Increasing demand for data capacity forces mobile network operators towards radio solutions with higher performance for being able to reduce CAPEX (CAPEX = CAPital EXpenditure) and OPEX (OPEX = OPerational EXpenditure). One such proposal is based on the idea to support multiple frequency transmission bands and multiple mobile communication standards via a same radio transmitter unit. However, when multiple frequency bands are processed by the same radio transmitter unit, for example amplified by one power amplifier, undesired inter-modulation products, are generated by the radio transmitter. For multi-band and fragmented band applications by using one radio transmitter, the inter-modulation products can be cataloged in in-band distortions and inter-band distortions depending on frequency positions of these distortions. In-band distortions are located within the frequency transmission bands and may cause high EVM (EVM = error vector magnitude) as well as high ACP (ACP = adjacent channel power). Inter-band distortions are inter-modulations products which are located outside and/or between the frequency transmission bands. Frequency positions of the inter-band distortions depend on a number of the frequency transmission bands and on frequency positions of the frequency transmission bands.

Different approaches have been developed for preventing the inter-modulation products in a transmitted multi-band radio frequency signal. A first approach commonly employed in the digital domain of the radio transmitter unit is to increase a sampling clock rate, which allows a wider sampling feedback bandwidth. However, the first approach is only useful up to a sampling rate of current state-of-the-art receive analog-to-digital convertors or techniques. In addition, the first approach will not be suitable if a frequency carrier separation is wider than a so-called feedforward and feedback sample-receive bandwidth.

According to a second approach especially for fragmented spectrum applications with large spacings between neighboring frequency bands baseband signals of the different frequency bands are separately converted to analogue radio frequency signals by separate conversion modules and are combined to a single radio frequency signal before being processed by a power amplifier. However, power amplifiers are nonlinear in nature and therefore cause high so-called ECM values (EVM = Error Vector Magnitude) and so-called ACP spectral components (ACP = Adjacent Channel Power), which results in in-band and inter-band spectral signal distortions.

Advanced DPD techniques (DPD = Digital Pre-Distortion) may be applied to compensate and remove the in-band distortions but not the inter-band distortions. The inter-band signal distortions may fall into a receive band and hence mask a wanted receive signal and therefore creating issues for a radio receiver unit, if not sufficiently suppressed e.g. by a duplex filter which is usually located between a radio transceiver unit and a connected antenna system. However, severe and strict rejection specifications of a mobile communication standard often result in a large cavity of the duplexer and hence result in undesirable additional physical dimensions and weight.

According to a third approach, power amplifiers with a so-called class-ABJ design or concept present different reactive termination solutions on both, fundamental and second harmonic, in order to improve performance (in terms of power, efficiency) e.g. in multi-band applications. Higher harmonics are terminated by short-circuit. When such a power amplifier is for example used for supporting a first frequency band at 2.1 GHz and a second frequency band at 2.6 GHz, the power amplifier is able to suppress inter-modulation products below 1.8 GHz and further inter-modulation products above 2.8 GHz.

### SUMMARY

Thus, an object of the embodiments of the invention is to provide a simple, cost-effective, space-saving and weight-saving solution for a transmitter method and a transmitter apparatus for preventing or reducing signal distortions in a multi-band radio frequency signal.

The object is achieved by a transmitter method for reducing unwanted signal distortions in a multi-band radio frequency signal. The transmitter method contains the step of amplifying by at least one power amplifier an input radio frequency signal, which contains at least one first frequency signal in a first frequency band and at least one second frequency signal in at least one second frequency band. The input radio frequency signal is amplified to an amplified multi-band radio frequency signal. The transmitter method further contains the step of manipulating the amplified multi-band radio frequency signal by at least one electrical component for decreasing below a predefined power threshold a power of signal distortions of the amplified multi-band radio frequency signal, which are localized in at least one frequency range outside the first frequency band and outside the at least one second frequency band. The transmitter method further contains the step of determining a negated error signal based on the signal distortions being rejected and reflected by the at least one electrical component.

The predefined power threshold may be for example 50 dB lower than a lowest predefined transmission power of the used frequency bands (i.e. of the first frequency band and the at least one second frequency band). Even if 50 dB suppression cannot be fully achieved, the transmitter method provides the advantage of using for example a duplex filter with reduced complexity.

The object is further achieved by a transmitter apparatus for reducing unwanted signal distortions in a multi-band radio frequency signal. The transmitter apparatus contains at least one power amplifier being adapted to amplify an input radio frequency signal, which contains at least one first frequency signal in a first frequency band and at least one second frequency signal in at least one second frequency band, to an amplified multi-band radio frequency signal.

The transmitter apparatus further contains at least one electrical component for manipulating the amplified multi-band radio frequency signal for decreasing below a predefined power threshold a power of signal distortions of the amplified multi-band radio frequency signal, which are localized in at least one frequency range outside the first frequency band and outside the at least one second frequency band.

The transmitter apparatus further contains means for determining a negated error signal based on the signal distortions being rejected and reflected by the at least one electrical component.

The transmitter apparatus even further contains means for coupling the negated error signal to the amplified multi-band radio frequency signal at an output of the at least one power amplifier being applied for the amplified multi-band radio frequency signal.

In embodiments, the means for determining the negated error signal may correspond to any determination unit, determination module, error correction amplifier, error correction amplifier unit etc. Hence, in embodiments the means for determining the negated error signal may contain an input for the rejected and reflected signal distortions, an electronic circuit, which generates from the rejected and reflected signal distortions the negated error signal, and an output for the negated error signal.

In embodiments, the means for coupling the negated error signal to the amplified multi-band radio frequency signal may correspond to any coupling unit, coupling module, etc. Hence, in embodiments the means for coupling the negated error signal to the amplified multi-band radio frequency signal may contain a first input for the amplified multi-band radio frequency signal, a second input for the negated error signal, a coupling structure for superimposing the amplified multi-band radio frequency signal and the negated error signal, and an output for the superimposed signal based on the amplified multi-band radio frequency signal and further based on the negated error signal.

The object is even further achieved by a network node, which contains the transmitter apparatus.

The embodiments provide possibilities to suppress inter-band signal distortions by several types of hardware implementation based on filter modules or matched networks. The embodiments provide a main advantage of getting rid of the inter-band distortions, which cannot be compensated by digital pre-distortion techniques. Therefore, the applied digital pre-distortion techniques can be fully focused on correcting in-band distortions.

The embodiments provide a further advantage of relaxing filtering requirements on duplex filters, which may be applied between the output port(s) of the transmitter apparatus and connected antenna system(s). The embodiments provide an even further advantage of not requiring more complex processing capabilities such as larger sampling bandwidths or larger clock rates. The embodiments provide a further advantage of not requiring more complex processing units such as transmit digital-to-analogue converters with an increased bandwidth or receive analogue-to-digital converters with an increased bandwidth in comparison to common transmit analogue-to-digital converters and common receive analogue-to-digital converters. The embodiments further provide an alternative solution instead of using a very broadband converter.

Further advantageous features of the embodiments of the invention are defined in the dependent claims and are described in the following detailed description.

### BRIEF DESCRIPTION OF THE FIGURES

The embodiments of the invention will become apparent in the following detailed description and will be illustrated by accompanying figures given by way of non-limiting illustrations.
Figure 1 shows schematically a block diagram of a transmitter apparatus for preventing signal distortions in a multi-band radio frequency signal and six inset figures with spectral distributions of wanted signals and unwanted signals at different locations in a processing chain of the transmitter apparatus according to a first exemplary embodiment.
Figure 2 shows schematically a flow diagram of a transmitter method for preventing signal distortions in a multi-band radio frequency signal according to a first exemplary embodiment.
Figure 3 shows schematically a flow diagram of a transmitter method for preventing signal distortions in a multi-band radio frequency signal according to a second exemplary embodiment.
Figure 4 shows schematically a block diagram of a transmitter apparatus for preventing signal distortions in a multi-band radio frequency signal according to a second exemplary embodiment.
Figure 5 shows schematically a flow diagram of a transmitter method for preventing signal distortions in a multi-band radio frequency signal according to a third exemplary embodiment.
Figure 6 shows schematically a block diagram of a transmitter apparatus for preventing signal distortions in a multi-band radio frequency signal and four inset figures with spectral distributions of wanted signals and unwanted signals at different locations in a processing chain of the transmitter apparatus according to a third exemplary embodiment.
Figure 7 shows schematically a flow diagram of a transmitter method for preventing signal distortions in a multi-band radio frequency signal according to a fourth exemplary embodiment.
Figure 8 shows schematically a block diagram of a transmitter apparatus for preventing signal distortions in a multi-band radio frequency signal and four inset figures with spectral distributions of wanted signals and unwanted signals at different locations in a processing chain of the transmitter apparatus according to a fourth exemplary embodiment.
Figure 9 shows schematically a flow diagram of a transmitter method for preventing signal distortions in a multi-band radio frequency signal according to a fifth exemplary embodiment.
Figure 10 shows schematically a block diagram of a transmitter apparatus for preventing signal distortions in a multi-band radio frequency signal according to a fifth exemplary embodiment.
Figure 11 shows schematically a flow diagram of a transmitter method for preventing signal distortions in a multi-band radio frequency signal according to a sixth exemplary embodiment.
Figure 12 shows schematically a block diagram of a network node which contains a transmitter apparatus according to an exemplarily embodiment.

### DESCRIPTION OF THE EMBODIMENTS

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

A splitting of processing functions across processing units shown in the Figures is not critical, and as can be understood by those skilled in the art that the number of processing units, the number of processing functions and an allocation of the processing functions to the processing units may vary without departing from the scope of the embodiments of the invention as defined in the appended claims. The number of the steps for performing the method(s) is not critical, and as can be understood by those skilled in the art that the number of the steps and the sequence of the steps may vary without departing from the scope of the embodiments of the invention as defined in the appended claims.

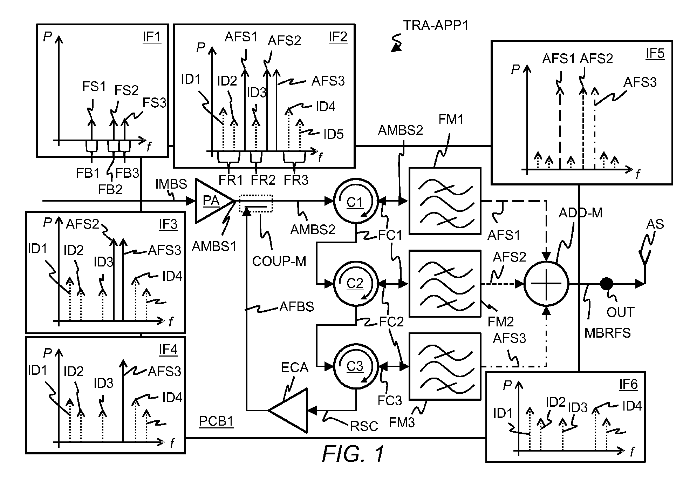

Figure 1 shows schematically a block diagram of a transmitter apparatus TRA-APP1, which is adapted to prevent signal distortions in a multi-band radio frequency signal MBRFS. The exemplarily shown transmitter apparatus TRA-APP1 contains a power amplifier PA, a coupling module COUP-M, a first circulator C1, a first filter module FM1, a second circulator C2, a second filter module FM2, a third circulator C3, a third filter module FM3, an adding module ADD-M, an output port OUT for outputting the multi-band radio frequency signal MBRFS to an antenna system AS and an error correction amplifier ECA in a feedback path to an output of the power amplifier PA. The transmitter apparatus TRA-APP1 preferably further contains a printed circuit board PCB1, on which the power amplifier PA, the coupling module COUP-M, the first circulator C1, the first filter module FM1, the second circulator C2, the second filter module FM2, the third circulator, the third filter module FM3, the adding module ADD-M and the error correction amplifier ECA may be installed. The coupling module COUP-M may be for example a directional coupler.

The first circulator C1, the second circulator C2 and the third circulator C3 may be for example circulators, which support a frequency range which contains the frequency bands FB1, FB2, FB3, FR1, FR2, FR3. Alternatively, the first circulator C1, the second circulator C2 and the third circulator C3 may be for example wideband circulators which support for example a frequency range from 1.8 GHz to 2.7 GHz. The first circulator C1, the second circulator C2 and the third circulator C3 may be for example three-port circulators, wherein a signal applied to port 1 comes out of port 2, a signal applied to port 2 comes out of port 3 and a signal applied to port 3 comes out of port 1.

The filter modules FM1, FM2, FM3 may be for example so-called band pass filter. The first filter module FM1 may be for example a first band pass filter with high rejection of for example 55 dB outside a pass band of the band pass filter, which means here outside a first frequency band FB1 of an amplified multi-band signal AMBS2. In a same way the second filter module FM2 may be for example a second band pass filter with high rejection of for example also 55 dB outside a second frequency band FB2 of the amplified multi-band signal AMBS2 and the third filter module FM3 may be for example a third band pass filter with high rejection of for example also 55 dB outside a third frequency band FB3 of the amplified multi-band signal AMBS2.

The adding module ADD-M may be for example a so-called power combiner and the output port OUT for outputting the multi-band radio frequency signal MBRFS may be for example an SMA connector (SMA = Sub-Miniature version A) or an N female connector.

The error correction amplifier ECA may be for example a linear power amplifier such as so-called class A power amplifier. The error correction amplifier ECA negates an input signal which is provided to the error correction amplifier ECA. A gain of the error correction amplifier ECA needs to be tuned to a power level of existing inter-band distortions. The principle function of the circulators C1, C2, C3, the filter modules FM1, FM2, FM3 and the error correction amplifier ECA in the feedback path is as follows: An error signal RSC is filtered out by the circulators C1, C2, C3 and rejected by the filter modules FM1, FM2, FM3. The error signal RSC is negated to a negated error signal AFBS by the error correction amplifier ECA and the negated error signal AFBS is added to an amplified multi-band signal AMBS1 by the coupling module COUP-M. If a time delay of the feedback path is small enough (e.g. in a range of a few picoseconds) and a power matching between the negated error signal AFBS and inter-band distortion signals ID1, ID2, ID3, ID4, ID5 (i.e. inter-modulation products) as part of the amplified multi-band signal AMBS1 of the output of the power amplifier PA is within a predefined range (e.g. over 98 %), good cancellation effects with respect to the signal distortions can be observed.

In an alternative embodiment the transmitter apparatus TRA-APP1 may contain two or more power amplifiers in a serial connection for providing a stepwise amplification of an input multi-band signal IMBS.

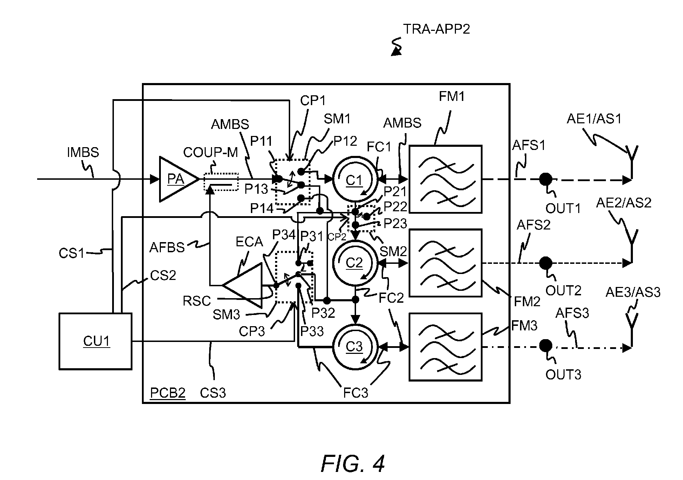

In a further alternative embodiment, a first amplified frequency signal AFS1 at an output of the first filter module FM1 may be provided to a first antenna element or a first antenna system, a second amplified frequency signal AFS2 at an output of the second filter module FM2 may be provided to a second antenna element or a second antenna system and a third amplified frequency signal AFS3 at an output of the third filter module FM3 may be provided to a third antenna element or a third antenna system (see also Figure 4).

The transmitter apparatus TRA-APP1 shown in Figure 1 is adapted to process the amplified multi-band signal AMBS which contains three separated frequency bands. In even further alternative embodiments, the transmitter apparatus TRA-APP1 may be adapted to process amplified multi-band signals which contains two separated frequency bands, four separated frequency bands or even more separated frequency bands.

The input multi-band signal IMBS is amplified by the power amplifier PA to the amplified multi-band signal AMBS1. The amplified multi-band signal AMBS1 contains in addition to the three amplified frequency signals AFS1, AFS2, AFS3 exemplarily five inter-band distortion signals ID1, ID2, ID3, ID4, ID5 (see second inset figure IF2 in Figure 1), in practice more inter-band distortion signals may be observed. The second inset figure IF2 shows an exemplarily spectral distribution of the amplified frequency signals AFS1, AFS2, AFS3 and the inter-band distortion signals ID1, ID2, ID3, ID4, ID5 with arbitrary frequency units of a frequency f and arbitrary power units of a power P. A first inter-band distortion signal ID1 and a second inter-band distortion signal ID2 is located in a first frequency range FR1 below the first frequency band FB1. A third inter-band distortion signal ID3 is located in a second frequency range FR2 between the first frequency band FB1 and the second frequency band FB2. A fourth inter-band distortion signal ID4 and a fifth inter-band distortion signal ID5 are located in a third frequency range FR3 above the third frequency band FB3.

The amplified multi-band signal AMBS1 is provided to the coupling module COUP-M and is extracted from the coupling module COUP-M as the amplified multi-band signal AMBS2. The amplified multi-band signal AMBS2 is provided to the first circulator C1, which may be the port 1 of a first three-port circulator. The amplified multi-band signal AMBS2 is extracted by the port 2 of the first circulator C1 and is provided to the first filter module FM1. The first filter module FM1 is only traversable by the amplified first frequency signal AFS1 and filters the amplified multi-band signal AMBS2 in such a way, that only the amplified first frequency signal AFS1 is provided unimpaired or undamped to the adding module ADD-M. All other frequency components of the amplified multi-band signal AMBS2 are nearly completely rejected by the first filter module FM1 and are fed back or reflected back as first spectral components FC1 to the port 2 of the first circulator C1. The first spectral components FC1 contain the two amplified frequency signals AFS2, AFS3 and the five inter-band distortion signals ID1, ID2, ID3, ID4, ID5 (see third inset figure IF3 in Figure 1). The third inset figure IF3 shows an exemplarily spectral distribution of the amplified frequency signals AFS2, AFS3 and the inter-band distortion signals ID1, ID2, ID3, ID4, ID5 with arbitrary frequency units of a frequency f and arbitrary power units of a power P.

The first spectral components FC1 are extracted by the port 3 of the first circulator C1 and are provided to the port 1 of the second circulator C2. The first spectral components FC1 are extracted by the port 2 of the second circulator C2 and are provided to the second filter module FM2. The second filter module FM2 is only traversable by the amplified second frequency signal AFS2 and filters the first spectral components FC1 in such a way, that only the amplified second frequency signal AFS2 is provided unimpaired or undamped to the adding module ADD-M. All other frequency components of the first spectral components FC1 are nearly completely rejected by the second filter module FM2 and are fed back or reflected back as second spectral components FC2 to the port 2 of the second circulator C2. The second spectral components FC2 contain the amplified third frequency signal AFS3 and the five inter-band distortion signals ID1, ID2, ID3, ID4, ID5 (see fourth inset figure IF4 in Figure 1). The fourth inset figure IF4 shows an exemplarily spectral distribution of the amplified third frequency signal AFS3 and the inter-band distortion signals ID1, ID2, ID3, ID4, ID5 with arbitrary frequency units of a frequency f and arbitrary power units of a power P.

The second spectral components FC2 are extracted by the port 3 of the second circulator C2 and are provided to the port 1 of the third circulator C3. The second spectral components FC2 are extracted by the port 2 of the third circulator C3 and are provided to the third filter module FM3. The third filter module FM3 is only traversable by the amplified third frequency signal AFS3 and filters the second spectral components in such a way, that only the amplified third frequency signal AFS3 is provided unimpaired or undamped to the adding module ADD-M. The adding module ADD-M combines the amplified first frequency signal AFS1, the amplified second frequency signal AFS2 and the amplified third frequency signal AFS3 to the amplified multi-band radio frequency signal MBRFS, which contains the inter-band distortion signals ID1, ID2, ID3, ID4, ID5 with a reduced level. An attenuation level depends on the power class of the transmitter apparatus TRA-APP1. The 50 dB suppression as mentioned above is a realistic value, but is also depending on filter module quality etc. (see fifth inset figure IF5 in Figure 1). The fifth inset figure IF5 shows the amplified multi-band radio frequency signal MBRFS with arbitrary frequency units of a frequency f and arbitrary power units of a power P.

All other frequency components of the second spectral components FC2 are nearly completely rejected by the third filter module FM3 and are fed back or reflected back as third spectral components FC3 to the port 2 of the third circulator C3. The third spectral components FC3 only contain the five inter-band distortion signals ID1, ID2, ID3, ID4, ID5 (see sixth inset figure IF6 in Figure 1). The sixth inset figure IF6 shows the inter-band distortion signals ID1, ID2, ID3, ID4, ID5 with arbitrary frequency units of a frequency f and arbitrary power units of a power P.

The third spectral components FC3 are extracted by the port 3 of the third circulator C3 and are provided as the error signal RSC to the error correction amplifier ECA, whose functionality is already described above in one of the previous paragraphs. The error correction amplifier ECA outputs the negated error signal AFBS which is provided to the coupling module COUP-M. The coupling module COUP-M provides or generates a superposition of the amplified multi-band signal AMBS1 and of the negated error signal AFBS.

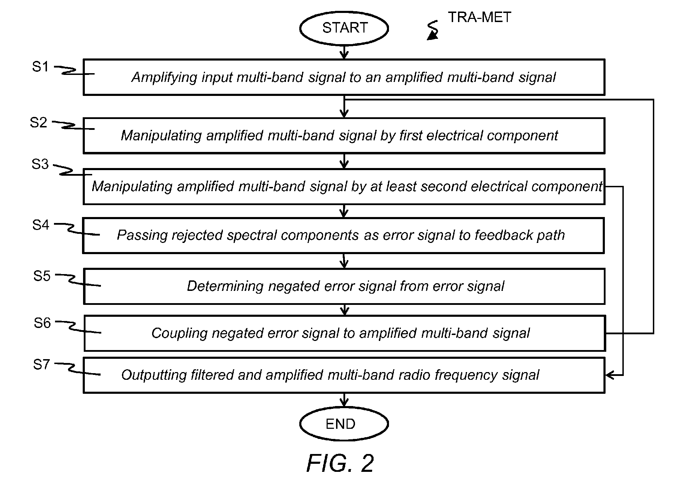

Figure 2 shows a flow diagram of a basic transmitter method TRA-MET of all embodiments for preventing the signal distortions ID1, ID2, ID3, ID4, ID5 in the multi-band radio frequency signal MBRFS. The transmitter method TRA-MET1 describes basic processing steps of the transmitter apparatuses TRA-APP1, TRA-APP2, TRA-APP3, TRA-APP4, TRA-APP5.

When the input multi-band signal IMBS enters a section of the transmitter apparatus TRA-APP1 as shown in Figure 1, in a first step S1 the input multi-band signal IMBS is amplified by the power amplifier PA to the amplified multi-band signal AMBS1.

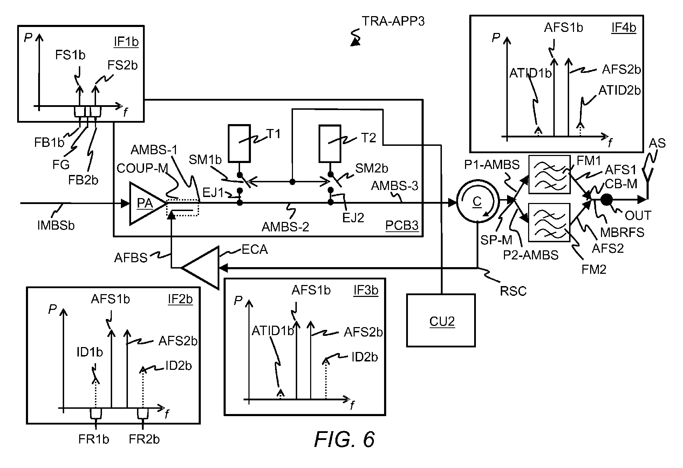

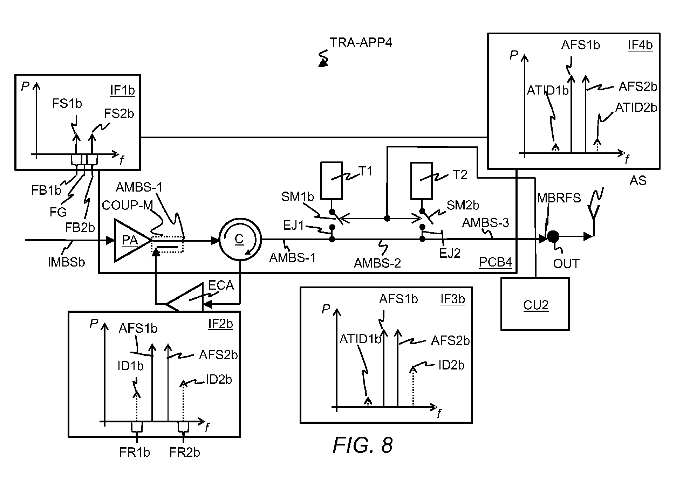

In a further step S2, a first electrical component manipulates the amplified multi-band signal AMBS2 or extracts the amplified first frequency signal AFS1 in such a way that an electrical power of a first signal distortion or a first group of signal distortions (the first and second inter-band distortion signals ID1, ID2) as part of the amplified multi-band signal AMBS2 is decreased below the predefined power threshold. The first electrical component may be for example a first filter module FM1 as shown in Figure 1. Another embodiment for the first electrical component will be described with respect to Figures 6 and 8.

In a next step S3, at least one second electrical component manipulates the amplified multi-band signal AMBS2 (the first spectral components FC1 with respect to the embodiment of Figure 1) or extracts the amplified second frequency signal AFS2 and preferably also the amplified third frequency signal AFS3 in such a way that an electrical power of at least one second signal distortion or at least one second group of signal distortions (the third, fourth and fifth inter-band distortion signals ID3, ID4, ID5) as part of the amplified multi-band signal AMBS2 is decreased below the predefined power threshold. The at least one second electrical component may be for example a second filter module FM1 and preferably a third filter module FM3 as shown in Figure 1. Another embodiment for the at least second electrical component will be described with respect to the Figures 6 and 8.

In a first passage by a further step S7, the output port OUT outputs the filtered and amplified radio frequency signal MBRFS to the antenna system AS. In such a case, the filtered and amplified radio frequency signal MBRFS has been not modified by the negated error signal from the feedback path during processing within the transmitter apparatus TRA-APP1.

By a next step S4, the third spectral components FC3, which have been rejected and reflected by the first electrical component FM1 and/or the at least second electrical component FM2, FM3 are passed as the error signal RSC to the feedback path.

In a further step S5, the negated error signal AFBS is determined or generated based on or from the error signal RSC for example by the error correction amplifier ECA.

In a next step S6, the negated error signal AFBS is coupled to the amplified multi-band signal AMBS1 by applying for example the coupling module COUP-M. Thereby, the amplified multi-band signal AMBS2 is generated.

For a second passage a next step after the step S6 is the again the step S2.

After the second passage using the step S7, the output port OUT outputs the filtered and amplified radio frequency signal MBRFS to the antenna system AS. In such a case, the filtered and amplified radio frequency signal MBRFS has been modified by the negated error signal from the feedback path during processing within the transmitter apparatus TRA-APP1.

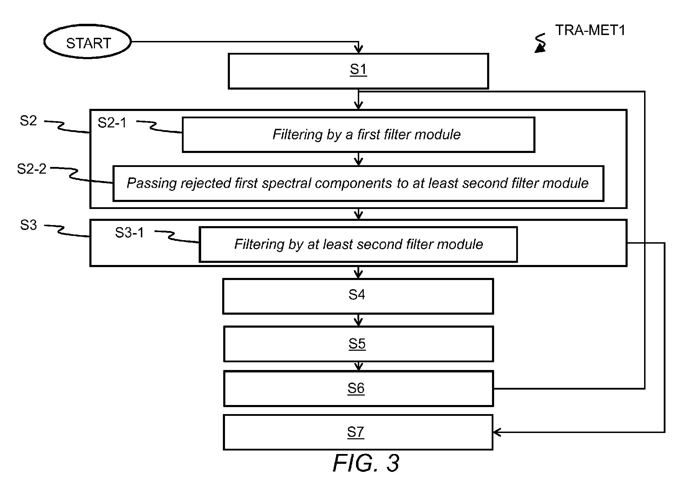

Figure 3 shows a flow diagram of a transmitter method TRA-MET1, which is based on the transmitter method TRA-MET shown in Figure 2 and which contains additional method steps for the transmitter apparatus embodiment shown in Figure 1. The elements in Figure 3 that correspond to elements of Figure 2 have been designated by same reference numerals and in general are not described again for simplification. The transmitter method TRA-MET1 describes further processing steps of the transmitter apparatus TRA-APP1.

The step S2 contains sub-steps S2-1, S2-2. In a first sub-step S2-1, the first filter module FM1 filters the amplified input multi-band signal AMBS2. By a further sub-step S2-2, the first circulator C1 passes the rejected first spectral components FC1 of the amplified multi-band signal AMBS2 to the second filter module FM2.

The step S3 contains a sub-step S3-1. By the sub-step S3-1, the second filter module FM2 filters the first spectral components FC1 and the third filter module FM3 filters the second spectral components FC2.

Figure 4 shows schematically a block diagram of a further transmitter apparatus TRA-APP2, which is also adapted to prevent signal distortions in the multi-band radio frequency signal MBRFS. The elements in Figure 4 that correspond to elements of Figure 1 have been designated by same reference numerals and in general are not described again for simplification.

In contrast to the transmitter apparatus TRA-APP1 shown in Figure 1, the transmitter apparatus TRA-APP2 does not contain a single output port for outputting the filtered and amplified multi-band radio frequency signal but contains three output ports OUT1, OUT2, OUT3. The output ports OUT1, OUT2, OUT3 may be for example SMA connections or N connections. Alternatively, the transmitter apparatus TRA-APP2 may contain a single output port in a same way as shown in Figure 1 for the transmitter apparatus TRA-APP1.

A first output port OUT1 is connected to an output of the first filter module FM1. This allows providing the first amplified frequency signal AFS1 to a first antenna element AE1 or a first antenna system AS1. A second output port OUT2 is connected to an output of the second filter module FM2. This allows providing the second amplified frequency signal AFS2 to a second antenna element AE2 or a second antenna system AS2. A third output port OUT3 is connected to an output of the third filter module FM3. This allows providing the third amplified frequency signal AFS3 to a third antenna element AE3 or a third antenna system AS3.

Further in contrast to Figure 1, the transmitter apparatus TRA-APP2 contains a first switch module SM1, a second switch module SM2, a third switch module SM3 and a control unit CU1, which allows to control the first switch module SM1 by a first control signal CS1, to control the second switch module SM2 by a second control signal CS2 and to control the third switch module SM3 by a third control signal CS3. The switch modules SM1, SM2, SM3 may be for example so-called MEMS (MEMS = micro electro mechanical systems).

The transmitter apparatus TRA-APP2 preferably further contains a printed circuit board PCB2, on which the power amplifier PA, the coupling module COUP-M, the first circulator C1, the first filter module FM1, the second circulator C2, the second filter module FM2, the third circulator, the third filter module FM3, the error correction amplifier ECA, the first switch module SM1, the second switch module SM2 and the third switch module SM3 may be installed.

The first switch module SM1 is located between an output of the coupling module COUP-M and the port 1 of the first circulator C1 and may contain a single switch as shown in Figure 4 or may contain alternatively several switches. The first switch module SM1 contains an input port P11 and three output ports P12, P13, P14 and a control port CP1. The control port CP1 is connected to the control unit CU1 and is adapted to receive the first control signal CS1. A first output port 12 of the first switch module SM1 is connected to the port 1 of the first circulator C1. A second output port 13 of the first switch module SM1 is connected to an electrical connection between the port 3 of the first circulator C1 and a port 21 of the second switch module SM2. A third output port 14 of the first switch module SM1 is connected to an electrical connection between the port 3 of the second circulator C2 and a port 22 of the second switch module SM2.

The second switch module SM2 is located between the port 3 of the first circulator C1 and the port 1 of the second circulator C2 and is adapted to connect or disconnect the port 3 of the first circulator C1 from the port 1 of the second circulator C2.

The third switch module SM3 is located between the ports 3 of the circulators C1, C2, C3 and the error correction amplifier ECA. An electrical connection between the port 3 of the first circulator C1 and the port 1 of the second circulator C2 contains a junction, which is connected to a first input port P31 of the third switch module SM3. In a same way, an electrical connection between the port 3 of the second circulator C2 and the port 1 of the third circulator C1 contains a junction, which is connected to a second input port P32 of the third switch module SM3. In contrast to the embodiment of Figure 1, the port 3 of the third circulator C3 is not directly connected to the error correction amplifier ECA but is connected to a third input port P33 of the third switch module SM3.

Depending on an availability of the amplified first frequency signal AFS1 and/or an availability of the amplified second frequency signal AFS2 and/or an availability of the amplified third frequency signal AFS3 within the amplified multi-band signal AMBS2, the control unit CU1 controls and adjusts the switch modules SM1, SM2, SM3 for example according to following table:

| **AFS1 part of AMBS2** | **AFS2 part of AMBS2** | **AFS3 part of AMBS2** | **Connected ports of SM1** | **Connected ports of SM2** | **Connected ports of SM3** |
|---|---|---|---|---|---|
| X | | | P11 with P12 | P21 with P22 | P31 with P34 |
| | X | | P11 with P13 | P21 with P23 | P32 with P34 |
| | | X | P11 with P14 | P21 with P22 | P33 with P34 |
| X | X | | P11 with P12 | P21 with P23 | P32 with P34 |
| X | | X | P11 with P12 | P21 with P22 | P31 with P32 |
| | X | X | P11 with P13 | P21 with P23 | P33 with P34 |
| X | X | X | P11 with P12 | P21 with P23 | P33 with P34 |

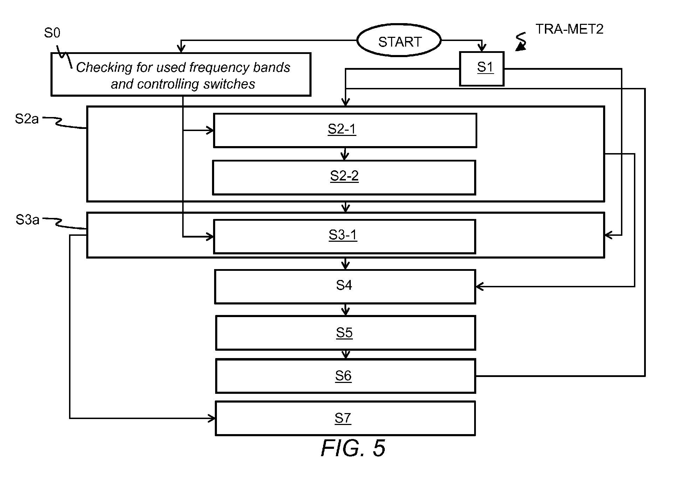

Figure 5 shows a flow diagram of a transmitter method TRA-MET2, which is based on the transmitter method TRA-MET and which contains additional method steps with respect to the transmitter apparatus TRA-APP2 which is shown in Figure 4. The elements in Figure 5 that correspond to elements of Figure 2 and Figure 3 have been designated by same reference numerals and in general are not described again for simplification.

The transmitter method TRA-MET2 contains a further step S0 for checking by the control unit CU1 a usage of frequency bands and controlling the switch module SM1 for switching on or off a filtering S2a by the first electrical component (here the first filter module FM1, see arrow from step S0 to step S2-1 for controlling feature) and for controlling the switch modules SM2, SM3 for switching on or off a filtering S3a by the at least one second electrical component (here the second filter module FM2 and/or the third filter module FM3, see arrow from step S0 to step S3-1 for controlling feature) depending on the usage of the frequency bands (here depending on an existence of the amplified first frequency signal AFS1 as part of the amplified multi-band signal AMBS2, depending on an existence of the amplified second frequency signal AFS2 as part of the amplified multi-band signal AMBS2 and depending on an existence of the amplified third frequency signal AFS3 as part of the amplified multi-band signal AMBS2; see also above table). The control unit CU1 may receive information which frequency bands are currently used for example by a higher layer entity such as a so-called central baseband unit.

This controlling decides about the next step after the step S1 for processing the amplified multi-band signal AMBS. When for example only filtering by the first filter module FM1 is required, a sequence of processing steps is S1, S2a and S4. When alternatively only filtering the second filter module FM2 and/or the third filter module FM3 is required a further sequence of processing steps may be S1, S3a and S4.

Figure 6 shows schematically a block diagram of a further transmitter apparatus TRA-APP3, which is also adapted to prevent signal distortions in the multi-band radio frequency signal MBRFS. The elements in Figure 6 that correspond to elements of Figure 1 have been designated by same reference numerals and in general are not described again for simplification.

The transmitter apparatus TRA-APP3 contains the power amplifier PA, the coupling module COUP-M, a first switchable frequency terminator T1, a first switch module SM1b for the first switchable frequency terminator T1, a second switchable frequency terminator T2 connected in series to the first switchable frequency terminator T1, a second switch module SM2b for the second switchable frequency terminator T2, a circulator C, a splitting module SP-M, the first filter module FM1, the second filter module FM2, a superimposing module CB-M, a feedback path from the circulator C to the coupling module COUP-M, the output port OUT and a control unit CU2 for controlling the first switch module SM1b and the second switch module SM2b. The feedback path contains the error correction amplifier ECA. The control unit CU1 may have a same functionality as the control unit CU1 shown in Figure 4.

The transmitter apparatus TRA-APP3 preferably further contains a printed circuit board PCB3. The printed circuit board PCB3 preferably contains the power amplifier PA, the coupling module COUP-M, the first switchable frequency terminator T1, the first switch module SM1b, the second switchable frequency terminator T2 and the second switch module SM2b.

The switchable frequency terminators T1, T2 are reactive terminations, terminating the unwanted inter-modulation distortions (at least the most relevant ones from a power contribution point of view) directly at corresponding intrinsic transistor outputs. The switch modules SM1b, SM2b may be preferably single switches, switching-on or -off e.g. single stub-terminations or multi stub-terminations for switching one or both of branch lines EJ1, EJ2 between a transmission line for the amplified multi-band signal AMBS-1, AMBS-2 and the switchable frequency terminators T1, T2. A length of the branch lines EJ1, EJ2 (taking into account an HF line section between intrinsic transistor and corresponding branch line) are adjusted in such a way, that a corresponding frequency is terminated. This means that different frequencies to be terminated need different lengths of the branch lines EJ1, EJ2.

In alternative embodiments, the transmitter apparatus TRA-APP3 may contain more than two switchable frequency terminators with corresponding switch modules controlled by the control unit CU2 and with corresponding frequency terminators.

The switch modules SM1b, SM2b may be for example diodes or MEMS (MEMS = Micro Electro Mechanical System). When no flexibility with respect to varying number of frequency bands to be processed by the transmitter apparatus TRA-APP3 is required, the transmitter apparatus TRA-APP3 may not contain the control unit CU2 and the switch modules SM1b, SM2b. In such a case, the frequency terminators T1, T2 may be directly connected to the RF amplifier matching network, which is located between the output of the power amplifier PA and the output port OUT of the transmitter apparatus TRA-APP3.

The frequency terminators T1, T2 may be for example notch filters, which may be composed of capacities, inductors, or micro-strip based signal terminations. The micro-strip based signal terminations may have a filtering effect of a band stop filter.

In an alternative embodiment, when the frequency terminators T1, T2 may be grounded by corresponding electrical groundings, the electrical junctions EJ1, EJ2 with the grounded frequency terminators T1, T2 may be similar to matching networks, which have specific resonances preferably at a centre of unused frequency gaps between used frequency bands FB1b, FB2b which contain frequency signals FS1b, FS2b. When implemented in a distributed array of series and/or parallel resonances as shown in Figure 6, such matching networks have a same filtering effect as the filter modules FM1, FM2, FM3 described above.

Internal structures of the frequency terminators T1, T2 are adapted to a corresponding frequency range for which each of the frequency terminators T1, T2 shall have a filter effect.

Preferably, sufficient frequency spacings between the non-contiguous frequency bands FB1b, FB2b are applied for avoiding to high losses for the frequency signals FS1b, FS2b by the filtering effect of the frequency terminators T1, T2. Depending on an availability of an amplified first frequency signal AFS1b and/or an availability of an amplified second frequency signal AFS2b as part of an amplified multi-band signal AMBS-1, the control unit CU2 controls and adjusts the switch modules SM1b, SM2b. If frequency terminatiors, which are currently not required due to a current operation mode with less frequency bands or only a single frequency band, are switched off, losses for the frequency signals FS1b, FS2b of the used frequency bands can be reduced and output power and efficiency of transmitter apparatus TRA-APP3 can be improved.

An input multi-band signal IMBSb exemplarily contains the two frequency signals FS1b, FS2b as wanted signals (see first inset figure IF1b in Figure 8). The first inset figure IF1b shows an exemplarily spectral distribution of the frequency signals FS1b, FS2b with arbitrary frequency units of a frequency f and arbitrary power units of a power P. A first frequency signal FS1b is located in the first frequency band FB1b which is a frequency band with smallest frequency values. A second frequency signal FS2b is located in the second frequency band FB2b which is a frequency band with larger frequency values than of the first frequency band FB1b and with a frequency gap FG between the first frequency band FB1b and the second frequency band FB2b.

The input multi-band signal IMBSb is amplified by the power amplifier PA to the amplified multi-band signal AMBS-1. The amplified multi-band signal AMBS-1 contains in addition to two amplified frequency signals AFS1b, AFS2b exemplarily two inter-band distortion signals ID1b, ID2b (see second inset figure IF2b in Figure 8). The second inset figure IF2b shows an exemplarily spectral distribution of the amplified frequency signals AFS1b, AFS2b and the inter-band distortion signals ID1b, ID2b with arbitrary frequency units of a frequency f and arbitrary power units of a power P. A first inter-band distortion signal ID1b has at least one frequency component which is smaller than frequency components of the first frequency FB1b. A second inter-band distortion signal ID2b is located in a second frequency range FR2b adjacent to the second frequency band FB2b and has at least one frequency component which is smaller than frequency components of the second frequency band FB2b.

The amplified multi-band signal AMBS-1 passes the first electrical junction EJ1, because the first switch module SM1b is in a switched-on state. Thereby, the first inter-band distortion signal ID1b is terminated because of the termination and filter effect of the frequency terminator T1 and the amplified multi-band signal AMBS-1 is converted into an amplified multi-band signal AMBS-2 which contains the two amplified frequency signals AFS1b, AFS2b, the remaining part of the terminated first inter-band distortion signal ID1b and the unaffected inter-band distortion signals ID2b (see third inset figure IF3b in Figure 8).

The amplified multi-band signal AMBS-2 passes the second electrical junction EJ2 which is terminated, because the second switch module SM2b is also in a switched-on state. Thereby, the second inter-band distortion signal ID2b is attenuated because of the attenuation and filter effect of the second frequency terminator T2 and the amplified multi-band signal AMBS-2 is converted into the filtered and amplified multi-band signal AMBS-3 which contains the two amplified frequency signals AFS1b, AFS2b, the remaining part of the first inter-band distortion signal ATID1b and the remaining part of the inter-band distortion signal ATID2b(see fourth inset figure IF4b in Figure 8).

By using the switchable frequency terminators T1, T2 the signal distortions ID1b, ID2b of the filtered and amplified multi-band signal AMBS-3 have been already reduced to some extend (e.g. 30 dB).

The filtered and amplified multi-band signal AMBS-3 is provided to a first port of the circulator C. The circulator C extracts the filtered and amplified multi-band signal AMBS-3 at a second port and provides the filtered and amplified multi-band signal AMBS-3 to a splitting point which is provided by the splitting module SP-M. The splitting module SP-M splits the filtered and amplified multi-band signal AMBS-3 into a first part P1-AMBS and a second part P2-AMBS. The first part P1-AMBS and the second part P2-AMBS may have equal power or may have different power, when the first frequency band FB1 and the second frequency FB2 are set to different gain values. The splitting module SP-M may be for example realized by appropriately tuned microstrip lines, ensuring, that amplified first frequency signal AFS1b sees a so-called thru at the splitting module SP-M for the first part P1-AMBS and a reflection for the second part P2-AMBS. For the amplified second frequency signal AFS2b it is vice versa. The first part P1-AMBS is provided to the first filter module FM1 and the second part P2-AMBS is provided to the second filter module FM2. The first filter module FM1 and the second filter module FM2 may have a same functionality as the filter modules FM1, FM2, which have described with respect to the embodiment of Figure 1. The first filter module FM1 extracts the first amplified frequency signal AFS1 and the second filter module FM2 extracts the second amplified frequency signal AFS2. The superimposing module CB-M superimposes at a combination point the first amplified frequency signal AFS1 and the second amplified frequency signal AFS2 for obtaining the filtered and amplified multi-band radio frequency signal MBRFS. The superimposing module CB-M is for example again realized by appropriately tuned microstrip lines. A length of microstrip line for the second amplified frequency signal AFS2 is tuned in that way, that the first amplified frequency signal AFS1 sees a reflection at the combination point for a path from the second filter module FM2 to the combination point and an thru for a path from the combination point to the output port OUT. The length of microstrip line for the first amplified frequency signal AFS1 is tuned vice versa.

Signal distortions ATID1b, ATID2b outside transmission bands of the filter modules FM1, FM2 are rejected and reflected by the filter modules FM1, FM2 and are provided on a backward path to the second port of the circulator C. The circulator C extracts the signal distortions ATID1b, ATID2b at a third port and provides the distortions ATID1b, ATID2b to the feedback path in a same way as described with respect to the transmitter apparatuses TRA-APP1, TRA-APP2 shown in Figure 1 and Figure 4.

A bandwidth of the circulator C is preferably adapted to the used transmission frequencies. The used transmission frequencies must be within a low insertion loss passband of the circulator C. If the used transmission frequencies are for example 1800 MHz and 2640 MHz, the circulator C must have for example a passband from 1750 MHz to 2700 MHz. The frequency ranges FR1b, FR2b may be located outside the low insertion loss passband of the circulator C. In such a case, the inter-band distortion signals ID1b, ID2b may be attenuated by the circulator C. In such a situation, the attenuation of the inter-band distortion signals ID1b, ID2b may be taken into account by the error correction amplifier ECA for obtaining a useful signal cancellation. When the inter-band distortion signals ID1b, ID2b may be attenuated with different levels by the circulator C, the error correction amplifier ECA may be replaced by a distributed error correction amplifier system (not shown in Figure 6 for simplification). The distributed error correction amplifier system may comprise at least two error correction amplifiers in a parallel connection. Therefore, the error signal RSC is split by corresponding directional couplers or microstrip lines into two or more frequency ranges. A first frequency range may contain inter-band distortion signal ID1b and at least a second frequency range may contain inter-band distortion signal ID2b. A first error correction amplifier with a corresponding amplification may provide a first negated error signal for the inter-band distortion signal ID1b and a second error correction amplifier with a further corresponding amplification may provide at least a second negated error signal for the inter-band distortion signal ID2b. By a further directional coupler or microstrip lines the first negated error signal and the at least second negated error signal are combined to the negated error signal AFBS.

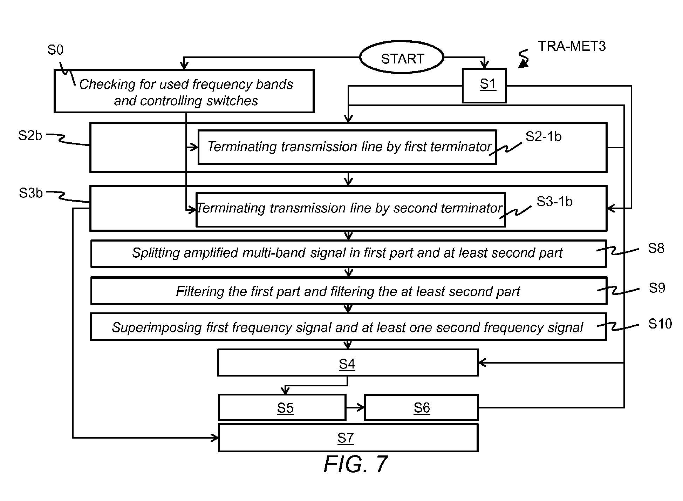

Figure 7 shows a flow diagram of a transmitter method TRA-MET3, which is based on the transmitter method TRA-MET and which contains additional method steps with respect to the transmitter apparatus TRA-APP3 which is shown in Figure 6. The elements in Figure 7 that correspond to elements of Figure 5 have been designated by same reference numerals and in general are not described again for simplification.

In contrast to the step S2a of the transmitter method TRA-MET2 (see Figure 5) the transmitter method TRA-MET3 contains step S2b. The step S2b contains the sub-step S2-1b for terminating by the first switchable frequency terminator T1 the transmission line between the power amplifier PA and the circulator C for the filtered and amplified multi-band signal AMBS-1 with respect to the inter-band distortion signal ID1b. Thereby, a reflection and termination is obtained for the inter-band distortion signal ID1b and in a best case, the filtered and amplified multi-band signal AMBS-2 passing the first switchable frequency terminator T1 does not contain the inter-band distortion signal ID1b. A switching on or off of the first frequency terminator T1 is preferably controlled by the step S0.

Further in contrast to the step S3a of the transmitter method TRA-MET2 (see Figure 5) the transmitter method TRA-MET3 contains step S3b. The step S3b contains the sub-step S3-1b for terminating by the second switchable frequency terminator T2 the transmission line between the power amplifier PA and the circulator C for the filtered and amplified multi-band signal AMBS-2 with respect to the inter-band distortion signal ID2b. Thereby, a reflection and termination is obtained for the inter-band distortion signal ID2b and in a best case, the filtered and amplified multi-band signal AMBS-3 passing the second switchable frequency terminator T2 does not contain the inter-band distortion signal ID2b. A switching on or off of the second frequency terminator T2 is preferably also controlled by the step S0.

The transmitter method TRA-MET3 further contains the step S8 of splitting the filtered and amplified multi-band signal AMBS-3 into the first part P1-AMBS and the second part P2-AMBS.

In a further step S9 the first part P1-AMBS is filtered by the first filter module FM1 for extracting the first amplified frequency signal AFS1 and the second part P2-AMBS is filtered by the second filter module FM2 for extracting the second amplified frequency signal AFS2. If a suitable transmission line structure is chosen as described above, in an ideal case a reflection and rejection of all spectral components being not located within the passbands of the first filter module FM1 and the second filter module FM2 occurs within the splitting point.

In a next step S10, the first amplified frequency signal AFS1 and the second amplified frequency signal AFS2 are superimposed to the amplified multi-band radio frequency signal MBRFS.

A next step after the step S10 is the step S4 as described with respect to the embodiment shown in Figure 2.

Figure 8 shows schematically a block diagram of a further transmitter apparatus TRA-APP4, which is also adapted to prevent signal distortions in the multi-band radio frequency signal MBRFS. The elements in Figure 8 that correspond to elements of Figure 6 have been designated by same reference numerals and in general are not described again for simplification.

In contrast to the transmitter apparatus TRA-APP3 shown in Figure 6, the transmitter apparatus TRA-APP4 does not contain the the splitting module SP-M, the first filter module FM1, the second filter module FM2 and the superimposing module CB-M. In addition, a location of the circulator C in the transmission line for the amplified multi-band signal AMBS-1, AMBS-2 has been changed from a location between the second switchable frequency terminator T2 and the splitting module SP-M to a location between the coupling module COUP-M and the first switchable frequency terminator T1.

A printed circuit board PCB4 preferably contains the power amplifier PA, the coupling module COUP-M, the circulator C, the first switchable frequency terminator T1, the first switch module SM1b, the second switchable frequency terminator T2 and the second switch module SM2b.

The circulator C provides the distortion signals ATID1b, ATID2b as reflected by the frequency terminators T1, T2 to the feedback path with error correction amplifier ECA.

The transmitter apparatus TRA-APP4 may be preferably applied, when power reductions for the distortion signals ATID1b, ATID2b provided by the switchable frequency terminators T1, T2 are already sufficient for an application of the amplified multi-band radio frequency signal MBRFS. If these power reductions are not sufficient, the transmitter apparatus TRA-APP3 which uses in addition the filter modules FM1, FM2 may be selected preferably.

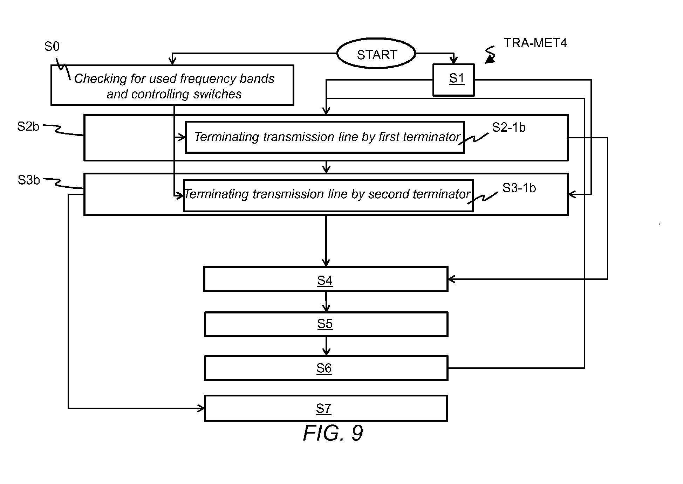

Figure 9 shows a flow diagram of a transmitter method TRA-MET4, which is based on the transmitter method TRA-MET. The elements in Figure 9 that correspond to elements of Figure 7 have been designated by same reference numerals and in general are not described again for simplification. Main difference between the transmitter method TRA-MET4 and the transmitter method TRA-MET3 is the fact, that the transmitter method TRA-MET4 does not contain the steps S8 and S9 of the transmitter method TRA-MET3.

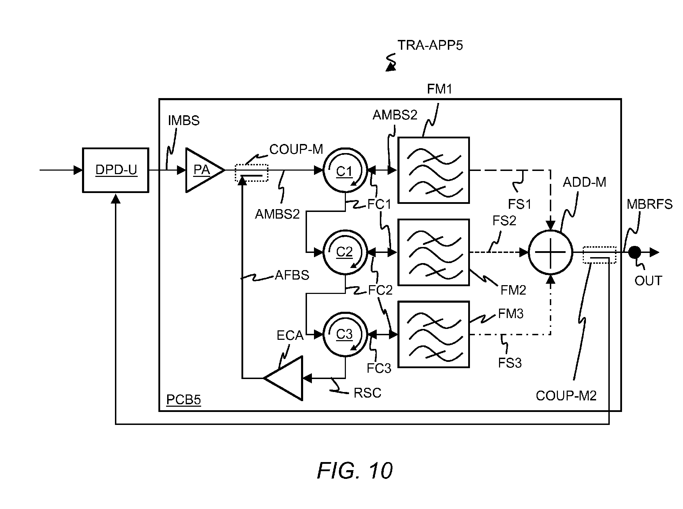

Figure 10 shows schematically a block diagram of a further transmitter apparatus TRA-APP5, which is also adapted to prevent signal distortions in the multi-band radio frequency signal MBRFS. The elements in Figure 10 that correspond to elements of Figure 1 have been designated by same reference numerals and in general are not described again for simplification.

In contrast to the transmitter apparatus TRA-APP1 shown in Figure 1, the transmitter apparatus TRA-APP5 contains as parts of a pre-distortion feedback path a pre-distortion unit DPD-U in an input processing path of the power amplifier PA and a further coupling module COUP-M2 between the adding module ADD-M and the output port OUT. The further coupling module COUP-M2 may be for example a directional coupler. The pre-distortion unit DPD-U may be preferably a digital pre-distortion unit and may be for example implemented as an algorithm of an FPGA (FPGA = Field-programmable gate array) or an ASIC (ASIC = Application-Specific Integrated Circuit).

The further coupling module COUP-M2 and the digital pre-distortion unit DPD-U are used for any conventional pre-distortion which is known to skilled persons in the art and is therefore not described here in further detail. The pre-distortion is applied for reducing or eliminating any in-band distortions of the filtered and amplified multi-band radio frequency signal MBRFS.

The transmitter apparatus TRA-APP5 preferably further contains a printed circuit board PCB5, on which the power amplifier PA, the coupling module COUP-M, the first circulator C1, the first filter module FM1, the second circulator C2, the second filter module FM2, the third circulator, the third filter module FM3, the adding module ADD-M, the further coupling module COUP-M2 and the error correction amplifier ECA may be installed.

According to alternative embodiments, the digital pre-distortion may be also applied by using one of the transmitter apparatuses TRA-APP2, TRA-APP3 or TRA-APP4 as shown in Figure 4, 6 or 8.

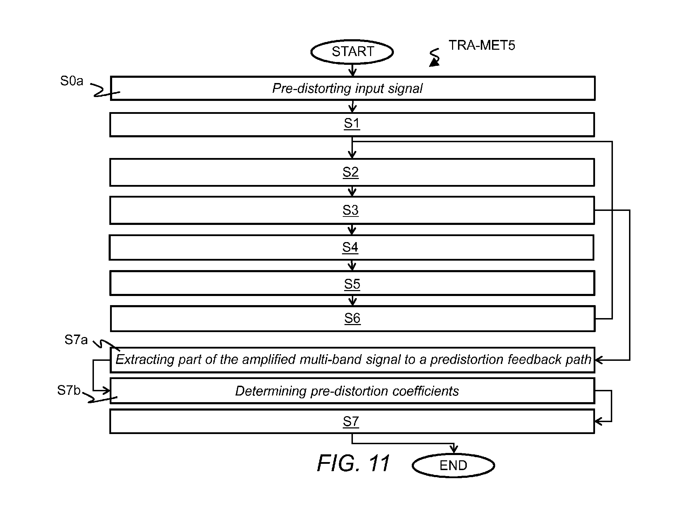

Figure 11 shows a flow diagram of a transmitter method TRA-MET5, which is based on the transmitter method TRA-MET shown in Figure 2 and which contains additional method steps. The elements in Figure 11 that correspond to elements of Figure 2 have been designated by same reference numerals and in general are not described again for simplification. The transmitter method TRA-MET5 describes further processing steps of the transmitter apparatus TRA-APP5.

By a step S0a which is performed before the step S1, the pre-distortion unit DPD-U pre-distorts the input multi-band signal IMBS based on pre-distortion coefficients which have been determined for a previously processed input multi-band signal.

Via a further step S7a which is performed after the step S3, the further coupling module COUP-M2 extracts a part of the filtered and amplified multi-band radio frequency signal MBRFS to the pre-distortion feedback path, which provides the extracted part to the pre-distortion unit DPD-U.

By a next step S7b, the pre-distortion unit DPD-U determines the pre-distortion coefficients based on the extracted part of the amplified multi-band radio frequency signal MBRFS according to any pre-distortion algorithm known to skilled persons in the art.

The step S7 is executed after the step S7b.

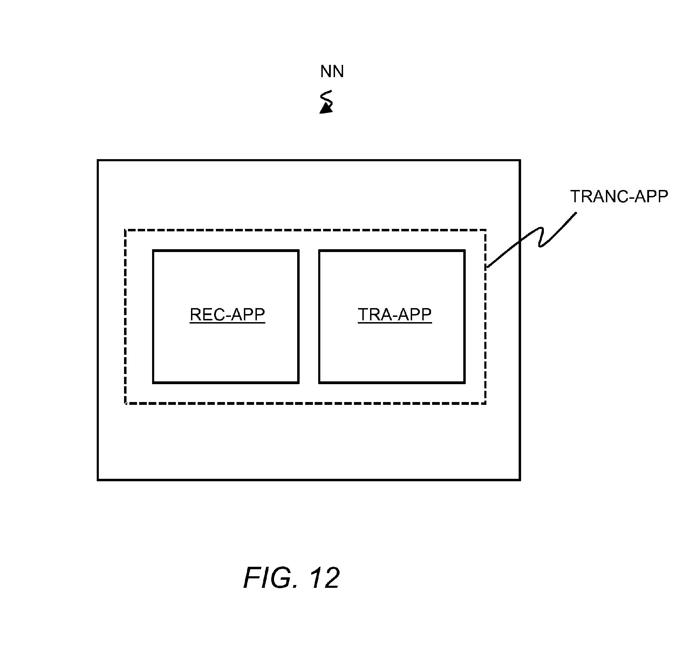

Figure 12 shows schematically a block diagram of a network node NN according to an exemplarily embodiment. The network node NN contains the transmitter apparatus TRA-APP and/or a receiver apparatus REC-APP. The transmitter apparatus TRA-APP and the receiver apparatus REC-APP may be components of a transceiver apparatus TRANC-APP. The transmitter apparatus TRA-APP is one of the transmitter apparatuses TRA-APP1, TRA-APP2, TRA-APP3, TRA-APP4, TRA-APP5 as described above with respect to Figures 1, 4, 6, 8 and 10.

The network node NN may be for example a base station, a relay, a repeater or a mobile station.

The term "base station" may be considered synonymous to and/or referred to as a base transceiver station, access point base station, access point, macro base station, macrocell, micro base station, microcell, femtocell, picocell etc. and may describe equipment that provides wireless connectivity via one or more radio links to one or more mobile stations. The base station BS1-1 may be for example an LTE Node B, an IEEE 802.11 access point, a WiMAX base station etc.

The term "repeater" may be considered synonymous to and/or referred to as an electronic device that receives a signal and simply retransmits it at a higher level or higher power, or onto another side of an obstruction, so that the signal can cover longer distances.

The term "relay" may be considered synonymous to and/or referred to as an electronic radio communication device that receives a signal and retransmits a different signal not only at a higher level or higher power, but also at a different frequency and/or different time slot and/or spreading code, to increase capacity in a wireless access network and to improve wireless link performance.

The term "mobile station" may be considered synonymous to, and may hereafter be occasionally referred to, as a mobile unit, mobile user, access terminal, user equipment, subscriber, user, remote station or a small cell, pico cell or femto cell when located in a moving vehicle such as a bus, a train or even a car. Each of the mobile stations UE1, UE2 may be for example a cellular telephone, a smart phone, a portable computer, a pocket computer, a hand-held computer, a personal digital assistant, a moving base station, a smart watch, a head mounted display such as a Google glass or a car-mounted mobile device such as a repeater or relay.

The term "macro base station" may be considered synonymous to and/or referred to a base station, which provides a radio cell having a size in a range of several hundred meters up to several kilometres. A macro base station usually has a maximum output power of typically tens of watts.

The term "micro base station" may be considered synonymous to and/or referred to a base station, which provides a radio cell having a size in a range of several tens of meters up to hundred meters. A micro base station usually has a maximum output power of typically several watts.

The term "macro cell" may be considered synonymous to and/or referred to a radio cell, which provides the widest range of all radio cell sizes. Macro cells are usually found in rural areas or along highways.

The term "micro cell" may be considered synonymous to and/or referred to a radio cell in a cellular network served by a low power cellular base station, covering a limited area (smaller than an area of a macro cell) such as a mall, a hotel, or a transportation hub. A microcell is referred to a group of radio cells, which contain pico cells and femto cells.

The term "pico cell" may be considered synonymous to and/or referred to a small cellular base station typically covering a small area, such as in-building (offices, shopping malls, train stations, stock exchanges, etc.), or more recently in-aircraft. In cellular networks, pico cells are typically used to extend coverage to indoor areas where outdoor signals do not reach well, or to add network capacity in areas with very dense phone usage, such as train stations.

The term "femto cell" may be considered synonymous to and/or referred to a small, low-power cellular base station, typically designed for use in a home or small business. A broader term which is more widespread in the industry is small cell, with femto cell as a subset.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for performing a certain function" shall be understood as functional blocks comprising circuitry that is adapted for performing the certain function, respectively. Hence, a "means for something" may as well be understood as a "means being adapted or suited for something". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, DSP hardware, network processor, ASIC, FPGA, read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the detailed description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that the transmitter methods TRA-MET, TRA-MET1, TRA-MET2, TRA-MET3, TRA-MET4, TRA-MET5 disclosed in the specification or in the claims may be implemented by a device having means for performing each of the respective steps of these methods. Preferably, a computer program product may contain computer-executable instructions for performing the transmitter methods TRA-MET, TRA-MET1, TRA-MET2, TRA-MET3, TRA-MET4, TRA-MET5, when the computer program product is executed on a programmable hardware device such as a DSP, an ASIC or an FPGA. Preferably, a digital data storage device may encode a machine-executable program of instructions to perform one of the transmitter methods TRA-MET, TRA-MET1, TRA-MET2, TRA-MET3, TRA-MET4, TRA-MET5.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. A transmitter method (TRA-MET, TRA-MET1, TRA-MET2, TRA-MET3, TRA-MET4, TRA-MET5) for reducing unwanted signal distortions in a multi-band radio frequency signal (MBRFS) comprising:
- amplifying (S1) an input radio frequency signal (IMBS) comprising at least one first frequency signal (FS1) in a first frequency band (FB1, FB1b) and at least one second frequency signal (FS2, FS3) in at least one second frequency band (FB2, FB3, FB2b) by at least one power amplifier (PA) to an amplified multi-band radio frequency signal (AMBS1),
- manipulating (S2, S3) said amplified multi-band radio frequency signal (AMBS2) by at least one electrical component (FM1, FM2, FM3, T1, T2) for decreasing below a predefined power threshold a power of signal distortions (ID1, ID2, ID3, ID4, ID5, ID1b, ID2b) of said amplified multi-band radio frequency signal (AMBS2) being localized in at least one frequency range (FR1, FR2, FR3, FR1b, FR2b) outside said first frequency band (FB1, FB1b) and outside said at least one second frequency band (FB2, FB3, FB2b),
- determining (S5) a negated error signal (AFBS) based on said signal distortions (ID1, ID2, ID3, ID4, ID5, ID1b, ID2b) being rejected and reflected by said at least one electrical component (FM1, FM2, FM3, T1, T2), and
- coupling (S6) said negated error signal (AFBS) to said amplified multi-band radio frequency signal (AMBS) at an output of said at least one power amplifier (PA) for said amplified multi-band radio frequency signal (AMBS).

2. Transmitter method (TRA-MET, TRA-MET1, TRA-MET2, TRA-MET3, TRA-MET4, TRA-MET5) according to claim 1, wherein each of said at least one electrical component (FM1, FM2, FM3, T1, T2) is adapted for decreasing below said predefined power threshold said power of said signal distortions (ID1, ID2, ID3, ID4, ID5, ID1b, ID2b) in a dedicated frequency range (FR1, FR2, FR3, FR1b, FR2b) outside said first frequency band (FB1, FB1b) and outside said at least one second frequency band (FB2, FB3, FB2b).

3. Transmitter method (TRA-MET1) according to any of the preceding claims, wherein said manipulating (S2, S3) by said at least one electrical component (FM1, FM2, FM3, T1, T2) comprises:
- filtering (S2-1) by a first electrical component (FM1) of said at least one electrical component (FM1, FM2, FM3) said amplified multi-band radio frequency signal (AMBS) by let passing said first frequency signal (FS1) and by rejecting first spectral components (FC1) of said at least one second frequency band (FB2, FB3) and of said at least one frequency range (FR1, FR2, FR3) and passing (S2-2a) said first spectral components (FC1) from said first electrical component (FM1) to at least one second electrical component (FM2, FM3) of said at least one electrical component (FM1, FM2, FM3), and
- filtering (S3-1) by said at least one second filter module (FM2, FM3) said rejected first spectral components (FC1) by let passing said at least one second frequency signal (FS2, FS3) and by rejecting at least second spectral components (FC2) comprising signal components of said at least one frequency range (FR1, FR2, FR3),
and wherein said first electrical component (FM1) is a first filter module and wherein said at least one second electrical component (FM2, FM3) is at least one second filter module (FM2, FM3).

4. Transmitter method (TRA-MET3, TRA-MET4) according to claim 1 or claim 2, wherein said manipulating (S2) by said at least one electrical component (FM1, FM2, FM3, T1, T2) comprises terminating (S2-1b, S3-1b) by said at least one electrical component (T1, T2) a transmission line of said amplified multi-band radio frequency signal (AMBS-1) for reflecting at least one signal distortion (ID1b, ID2b) of said signal distortions (ID1, ID2, ID3, ID4, ID5, ID1b, ID2b), and and wherein said at least one electrical component (T1, T2) is at least one frequency terminator.

5. Transmitter method (TRA-MET3) according to claim 4, wherein said method (TRA-MET3) further comprises:
- splitting (S8) after said manipulating (S2) said amplified multi-band radio frequency signal (AMBS) into a first part (P1-AMBS) and at least one second part (P2-AMBS),
- filtering (S9) by a first filter module (FM1) said first part (P1-AMBS) and by at least one second filter module (FM2) said at least one second part (P2-AMBS) by let passing said first frequency signal (FS1b) and said at least one second frequency signal (FS2b) and by rejecting and reflecting spectral components outside said first frequency range (FB1b) and said at least second frequency range (FB2b), and
- superimposing (S10) said first frequency signal (AFS1) and said at least one second frequency signal (AFS2).

6. Transmitter method (TRA-MET2, TRA-MET3, TRA-MET4) according to any of the preceding claims, wherein said transmitter method (TRA-MET2, TRA-MET3, TRA-MET4) further comprises controlling (S0) said manipulating (S2) by said at least one electrical component (FM1, FM2, FM3, T1, T2) depending on an existence of said signal distortions (ID1, ID2, ID3, ID4, ID5, ID1b, ID2b) in said at least one frequency range (FR1, FR2, FR3, FR1b, FR2b).

7. Transmitter method (TRA-MET2, TRA-MET3, TRA-MET4) according to claim 6, wherein said controlling (S0) comprises switching on or switching off said at least one electrical component (FM1, FM2, FM3, T1, T2) by at least one switch (SM1, SM2, SM3, SM1b, SM2b).

8. Transmitter method (TRA-MET2, TRA-MET3, TRA-MET4) according to claim 7, wherein said at least one switch (SM1, SM2, SM3, SM1b, SM2b) is at least one micro-electromechanical system or at least one diode.

9. Transmitter method (TRA-MET5) according to any of the preceding claims, wherein said transmitter method (TRA-MET5) further comprises:
- extracting (S0a) a part of said amplified multi-band radio frequency signal (MBRFS) to a pre-distortion feedback path,
- determining (S7a) pre-distortion coefficients based on said part of said amplified multi-band radio frequency signal (MBRFS), and
- pre-distorting (S7b) said input radio frequency signal (IMBS) based on said pre-distortion coefficients.

10. A transmitter apparatus (TRA-APP1, TRA-APP2, TRA-APP3, TRA-APP4, TRA-APP5) for reducing unwanted signal distortions in a multi-band radio frequency signal (MBRFS) comprising:
- at least one power amplifier (PA) for amplifying an input radio frequency signal (IMBS) comprising at least one first frequency signal (FS1) in a first frequency band (FB1) and at least one second frequency signal (FS2, FS3) in at least one second frequency band (FB2, FB3) to an amplified multi-band radio frequency signal (AMBS1),
- at least one electrical component (FM1, FM2, FM3, T1, T2) for manipulating (S2, S3) said amplified multi-band radio frequency signal (AMBS2) for decreasing below a predefined power threshold a power of signal distortions (ID1, ID2, ID3, ID4, ID5, ID1b, ID2b) of said amplified multi-band radio frequency signal (AMBS2) being localized in at least one frequency range (FR1, FR2, FR3, FR1b, FR2b) outside said first frequency band (FB1) and outside said at least one second frequency band (FB2, FB3),
- means (ECA) for determining a negated error signal (AFBS) based on said signal distortions (ID1, ID2, ID3, ID4, ID5, ID1b, ID2b) being rejected and reflected by said at least one electrical component (FM1, FM2, FM3, T1, T2), and
- means (COUP-M) for coupling said negated error signal (AFBS) to said amplified multi-band radio frequency signal (AMBS) at an output of said at least one power amplifier (PA) for said amplified multi-band radio frequency signal (AMBS).

11. Transmitter apparatus (TRA-APP1, TRA-APP2, TRA-APP3, TRA-APP4, TRA-APP5) according to claim 10, wherein said at least one electrical component (FM1, FM2, FM3, T1, T2) is a frequency terminator (T1, T2) or a filter module (FM1, FM2, FM3).

12. Transmitter apparatus (TRA-APP, TRA-APP1, TRA-APP2, TRA-APP3, TRA-APP4, TRA-APP5) according to claim 10 or 11, wherein said transmitter apparatus (TRA-APP, TRA-APP1, TRA-APP2, TRA-APP3, TRA-APP4, TRA-APP5) further comprises a printed circuit board (PCB1, PCB2, PCB3, PCB4, PCB5) and wherein said printed circuit board comprises said at least one power amplifier (PA) and said at least one electrical component (FM1, FM2, FM3, T1, T2).

13. Transmitter apparatus (TRA-APP1, TRA-APP2, TRA-APP3, TRA-APP4, TRA-APP5) according to any of the preceding claim 10 to 12, wherein said transmitter apparatus (TRA-APP1, TRA-APP2, TRA-APP3, TRA-APP4, TRA-APP5) further comprises at least one circulator (C, C1, C2, C3) for providing said rejected and reflected signal distortions (ID1, ID2, ID3, ID4, ID5, ID1b, ID2b) to said means (ECA) for determining said negated error signal (AFBS).

14. Transmitter apparatus (TRA-APP1, TRA-APP2, TRA-APP3, TRA-APP4, TRA-APP5) according to claim 13, wherein said at least one circulator (C, C1, C2, C3) is located in a transmission line for said amplified multi-band radio frequency signal (AMBS1, AMBS2, AMBS-1, AMBS-2) between said at least one power amplifier (PA) and said at least one electrical component (FM1, FM2, FM3, T1, T2) or between said at least one electrical component (FM1, FM2, FM3, T1, T2) and filter modules (FM1, FM2).

15. Transmitter apparatus (TRA-APP) according to any of the preceding claims 10 to 14, wherein said means (ECA) for determining a negated error signal (AFBS) based on said signal distortions (ID1, ID2, ID3, ID4, ID5, ID1b, ID2b) is a single error correction amplifier (ECA) or a distributed error correction amplifier system comprising a first error correction amplifier with a first amplification factor for at least a first one of said signal distortions (ID1b, ID2b) and further comprising at least one second error correction amplifier with a second amplification factor for at least a second one of said signal distortions (ID1b, ID2b).
